# DEMANDE DE BREVET EUROPEEN

(11) **EP 1 320 123 A1**
(43) Date de publication de la demande: **18.06.2003**
(21) Numéro de dépôt: 02356232.5
(22) Date de dépôt: 18.11.2002
(51) Int. Cl.: H01L 21/02, H01L 23/522, H01L 27/08

(54) **Procédé de fabrication d'un composant électronique incorporant un micro-composant inductif**

(30) Priorité: 11.12.2001 FR 0115960
(71) Demandeur: Memscap, 38190 Bernin (FR)
(72) Inventeur: Girardie, Lionel, 38320 Eybens (FR); David, Jean-Baptiste, 38400 Saint Martin d'Heres (FR)
(74) Mandataire: Palix, Stéphane

(57) **Abrégé**

L'invention concerne un procédé permettant de fabriquer des composants électroniques incorporant un micro-composant inductif, disposé au dessus d'un substrat.
Un tel composant comporte :
- au moins une superposition d'une couche (10, 10a) de matériau à faible permittivité relative et d'une couche de masque dur, la première couche (10) de matériau à faible permittivité relative reposant sur la face supérieure du substrat (1) ;
- un ensemble de spires métalliques (39), définies au-dessus de la superposition de couches (10, 10a) de matériau à faible permittivité relative ;
- une couche (35) barrière à la diffusion du cuivre, présente sur les faces inférieure et latérales des spires métalliques (39).

## Description

### Domaine Technique

L'invention se rattache au domaine de la microélectronique. Plus précisément, elle vise un procédé permettant de réaliser des micro-composants inductifs sur un substrat, qui peut lui-même incorporer un circuit intégré.

Ces composants peuvent notamment être utilisé dans les applications de type radiofréquences, par exemple dans le domaine des télécommunications.

L'invention vise plus spécifiquement un procédé permettant d'obtenir des circuits possédant des performances nettement plus élevées que les composants existants, notamment en ce qui concerne la valeur du facteur de qualité. Le procédé objet de l'invention, limite également le nombre d'étapes nécessaires pour la réalisation de tels composants, et assure une bonne reproductibilité des caractéristiques des composants qu'il permet de fabriquer.

### Techniques antérieures

Dans le document FR 2 791 470, le Demandeur a décrit un procédé de fabrication permettant de réaliser des micro-inductances ou des micro-transformateurs au-dessus d'un substrat, et notamment au-dessus d'un circuit intégré. De façon résumée, ce procédé consiste à déposer une couche de matériau de faible permittivité relative puis à réaliser une gravure de ce matériau au niveau d'une ouverture réalisée dans un masque dur, à l'aplomb d'un plot de connexion avec le reste du circuit intégré, de manière à définir un trou d'interconnexion, également appelé "via".

Après avoir déposé une résine au-dessus du masque dur, on grave cette dernière pour former les canaux définissant la géométrie des spires du composant inductif. On procède par la suite à un dépôt de cuivre, par voie électrolytique, au-dessus du plot de connexion, et dans les canaux définis dans la résine supérieure.

Un tel procédé présente un certain nombre d'inconvénients, parmi lesquels on peut noter essentiellement le fait que l'étape de dépôt électrolytique assure à la fois la formation des spires du composant inductif, ainsi que le remplissage du trou d'interconnexion, permettant le contact avec le plot métallique relié au circuit intégré. Ces zones étant de profondeurs différentes, il s'ensuit que le dépôt électrolytique s'effectue de manière différente au niveau des spires et au niveau du trou d'interconnexion. On observe ainsi certaines irrégularités au niveau de la formation des spires qui sont préjudiciables à la bonne régularité des performances électriques du composant inductif.

En outre, lors de l'étape de gravure de la résine supérieure, il est nécessaire d'effectuer une gravure plus longue au niveau du trou d'interconnexion, par comparaison avec les zones dans lesquelles sont formés les canaux destinés à recevoir les spires. Cette différence de profondeur de gravure provoque une libération de composés chimiques au niveau du fond du trou d'interconnexion, ce qui perturbe l'opération ultérieure de dépôt électrolytique de cuivre.

Par ailleurs, la distance séparant le composant inductif du substrat est sensiblement égale à l'épaisseur de la couche de matériau de faible permittivité relative. Etant donné qu'il n'est pas possible d'augmenter l'épaisseur de cette couche de façon très importante, on conçoit qu'il n'est pas possible de diminuer la capacité parasite entre le composant inductif et le substrat en dessous d'une valeur dépendant de la mise en oeuvre du procédé.

Un des objectifs de l'invention est de pallier ces différents inconvénients, et notamment de permettre de réaliser des composants qui possèdent des caractéristiques dimensionnelles aussi précises que possible, de manière à conférer des performances électriques optimales et ainsi accroître l'intégration de composants en réduisant leur taille.

### Exposé de l'invention

L'invention concerne donc un procédé de fabrication d'un composant électronique. Un tel composant incorpore un micro-composant inductif, tel qu'une inductance ou un transformateur, qui est situé au-dessus d'un substrat, et relié à ce substrat, au moins par un plot métallique.

Conformément à l'invention, ce procédé se caractérise en ce qu'il comporte les étapes suivantes :
a) déposer sur le substrat au moins un empilement d'une couche de matériau à faible permittivité relative et d'une couche formant un masque dur ;
b) réaliser une ouverture dans le masque dur situé en position supérieure, à l'aplomb des plots métalliques ;
c) graver la ou les couches de matériau à faible permittivité relative et la ou les couches de masque dur sous-jacentes jusqu'au plot métallique, pour former un trou d'interconnexion ;
d) déposer une couche formant barrière à la diffusion du cuivre ;
e) déposer une couche amorce de cuivre ;
f) déposer par voie électrolytique une couche de cuivre emplissant le trou d'interconnexion et recouvrant la couche amorce ;
g) planariser la face supérieure jusqu'à faire apparaître la couche de masque dur située en position supérieure ;
h) déposer une couche de résine supérieure formée d'un matériau à faible permittivité relative ;
i) graver la couche de résine supérieure pour former les canaux définissant les spires du micro-composant inductif, et d'éventuels autres motifs conducteurs ;
j) déposer une couche barrière à la diffusion du cuivre ;
k) déposer une couche amorce de cuivre ;
l) déposer par voie électrolytique du cuivre au moins au-dessus des canaux ainsi gravés ;
m) planariser jusqu'à faire apparaître la couche de résine supérieure.

Ainsi, le procédé conforme à l'invention enchaîne un certain nombre d'étapes qui procurent certaines améliorations par rapport aux procédés de l'Art antérieur.

On notera notamment que l'on peut enchaîner le dépôt de plusieurs couches de matériau à faible permittivité relative, séparées chacune par une couche intermédiaire, de manière à augmenter très fortement la distance séparant le composant inductif du substrat. La capacité parasite entre le composant inductif et le substrat est donc fortement réduite, ce qui améliore grandement les performances de ce composant inductif, et notamment son facteur de qualité. On peut en effet, empiler au moins deux, trois, voire quatre ou cinq couches de matériau à faible permittivité relative, présentant chacune une épaisseur de l'ordre de dizaines de microns, ce qui permet d'espacer le composant inductif d'une distance de l'ordre ou supérieure à 50 microns par rapport au substrat. Cette valeur est à comparer à la dizaine de microns qui sépare la micro-inductance du substrat dans les procédés de l'Art antérieur.

On notera également que le dépôt électrolytique de cuivre intervient en deux étapes distinctes, à savoir tout d'abord une première étape permettant de combler le trou d'interconnexion, ce qui permet dans un premier temps de faire croître du cuivre jusqu'au niveau du plan inférieur du micro-composant inductif. Dans une seconde étape, on procède à un dépôt électrolytique de cuivre, qui forme simultanément les spires du composant inductif et la zone de liaison des spires avec la via déjà comblée dans l'étape de dépôt antérieur.

De la sorte, en dissociant ces deux dépôts de cuivre, on assure une homogénéité de ce dépôt qui est favorable à la régularité de la forme des spires, et donc à la qualité des performances électriques ainsi qu'à la reproductibilité du procédé.

Après chacune de ces étapes de dépôt électrolytique de cuivre, on procède à une planarisation qui permet d'obtenir un état de surface optimal et d'éliminer les zones de la couche barrière à diffusion du cuivre et de la couche amorce qui se trouvent à l'extérieur des zones où le cuivre doit rester apparent pour les opérations ultérieures.

On notera également que ce procédé peut être utilisé sur différents types de substrat. Ainsi, dans une première famille d'applications, le procédé peut être mis en oeuvre sur un substrat semi-conducteur, et notamment un substrat ayant été préalablement fonctionnalisé pour former un circuit intégré.

Dans d'autres types d'applications, il peut s'agir d'un substrat spécifique, tel qu'un substrat amorphe du type verre ou quartz, ou plus généralement un substrat possédant des propriétés électriques, optiques ou magnétiques appropriées à certaines applications.

En pratique, le matériau de faible permittivité relative, qui est déposé sur le substrat peut être du benzocyclobutène (BCB), ou encore un matériau analogue, dont la permittivité relative est typiquement inférieure à 3.

En pratique, l'épaisseur de cette couche de matériau de faible permittivité relative peut être comprise entre 10 et 40 micromètres, étant préférentiellement voisine de 20 micromètres.

L'épaisseur de cette couche (ou de ces couches lorsqu'il y en a plusieurs empilées) définit sensiblement l'éloignement entre le composant inductif et le substrat. Cette distance, combinée avec la permittivité relative du matériau de cette couche définit la capacité parasite existant entre le composant inductif et le substrat, capacité qu'il est hautement souhaitable de minimiser.

En pratique, le matériau utilisé pour former le masque dur au-dessus du BCB peut être choisi dans le groupe comprenant : SiC, SiN, Si₃N_{4,} SiO₂, SiOC, SiON, WSi₂, Y₂O_{3,} pris isolément ou en combinaison. Ces matériaux présentent des propriétés de bonne compatibilité avec le BCB, notamment une forte adhésion comme masque dur sur la surface du BCB. Ces matériaux présentent des propriétés mécaniques adéquates pour leur utilisation en masquinage. Par ailleurs, cette couche servant de masque dur à des fins de gravure des trous d'interconnexion, une sélectivité élevée de la gravure du BCB par rapport à ces matériaux est requise, de manière à éviter toute sur-gravure du BCB et obtenir ainsi les profiles souhaités sans délaminage.

Les contraintes entre le BCB et le masque dur pourraient en effet se transmettre jusqu'au substrat, et provoquer d'éventuelles ruptures de ce dernier. Ces phénomènes de trop fortes contraintes sont notamment observés dans les procédés de l'Art antérieur qui utilisent des couches épaisses de certains métaux pour réaliser le masque dur au-dessus d'une couche de BCB avec pour conséquence des risques de mauvaise adhésion.

Selon une autre caractéristique de l'invention, on dépose une couche formant barrière à la diffusion du cuivre au-dessus du masque dur. Cette couche barrière permet d'isoler la couche sous-jacente du cuivre qui va être ultérieurement déposée, notamment sous la forme de la couche amorce. Cette couche barrière caractéristique évite la migration du cuivre à travers la couche de faible permittivité relative, ce qui aurait pour effet d'augmenter cette permittivité, et donc d'augmenter la capacité parasite entre le micro-composant inductif et le substrat, et créer des sources de défectivité. Cette couche barrière évite également que le cuivre ne vienne migrer à l'intérieur du substrat, avec des conséquences préjudiciables sur la qualité ou le fonctionnement du circuit intégré.

On remarquera que le dépôt de la couche barrière à la diffusion s'effectue en deux étapes distinctes. La couche déposée lors de la première étape forme une barrière vis à vis du cuivre situé dans la via. La seconde étape permet le dépôt de cette couche barrière de telle sorte qu'elle recouvre les faces latérales et inférieure des différentes spires et motifs conducteurs qui sont réalisés ultérieurement. Cette seconde couche barrière évite la migration du cuivre des spires vers la couche de résine supérieure.

En pratique, 1a couche barrière peut être réalisée en tungstène ou à partir d'un matériau choisi dans le groupe comprenant TiW, Ti, TiN, Ta, TaN, WN, Re, Cr, Os, Mo et Ru. Ces matériaux peuvent être utilisés seuls ou en combinaison.

Avantageusement en pratique, la couche barrière à la diffusion peut présenter une épaisseur comprise entre 100 et 400 Å.

Selon une autre caractéristique de l'invention, le procédé peut comporter une étape d'enrichissement de la couche amorce de cuivre. Cette couche amorce joue le rôle d'électrode pour les dépôts ultérieurs de cuivre par voie électrolytique.

Il peut s'avérer utile dans certaines conditions, d'améliorer la régularité et la morphologie, l'état d'oxydation du cuivre, la rugosité et le déficit de sites de nucléation de la couche amorce. Cette couche amorce est déposée par voie physico-chimique et plus particulièrement par la technique dite de pulvérisation et selon sa variante de "métal ionisé à source plasma" ou IMP. Dans ce cas, on procède à une étape d'enrichissement de cette couche amorce en soumettant la couche amorce à un bain d'électrolytes. Ce bain comprenant des sels de cuivre permet un dépôt de cuivre dans les éventuels espaces existants entre les îlots de cuivre préalablement déposés lors de la réalisation de la couche amorce. Cette étape d'enrichissement assure donc un lissage de cette couche amorce de manière à améliorer le dépôt électrolytique ultérieur.

Avantageusement en pratique, on peut procéder à des étapes de recuit, permettant de faire croître la taille des cristaux de cuivre déposés lors des étapes de dépôt électrolytique. Cette étape de recuit, typiquement par exposition du composant à une température comprise entre 150 et 400°C pendant une durée de quelques minutes, assure une uniformité cristalline du cuivre déposé, et donc l'homogénéité et le caractère conducteur du cuivre qui formera les spires du composant inductif. On améliore ainsi les qualités électriques du composant en diminuant le nombre de singularités pouvant être la source de points résistifs ou de faiblesses mécaniques.

Avantageusement en pratique, on peut procéder à une étape de décontamination du cuivre susceptible de migrer dans le substrat, notamment au niveau des faces latérales et postérieures du substrat ainsi qu'à sa circonférence. En effet, lorsque le composant est soumis à un bain contenant des sels de cuivre solubles, il convient d'éliminer un excès de dépôt de cuivre. En effet, lorsque ce métal est déposé selon des techniques d'électrolyse et selon une distribution spécifique de courant entre la cathode et l'anode, on observe généralement un excès de dépôt de cuivre en circonférence du substrat. Par ailleurs, le processus de i convection et de transfert de masse, qui est à la base de la technique de dépôt par électrolyse de l'élément de cuivre, engendre sur les faces latérales ou postérieures du substrat un flux possible et une diffusion sur certaines zones du substrat. Afin d'éviter leur éventuelle migration dans le substrat, il est recommandé d'utiliser cette étape. Cette étape de décontamination peut également permettre de régulariser la forme des zones sur lesquelles s'est effectué le dépôt électrolytique de cuivre, notamment au niveau des arêtes des spires.

En pratique, cette étape de décontamination peut avoir lieu après l'une ou l'autre des deux étapes de dépôt électrolytique.

Selon d'autres caractéristiques de l'invention, on peut procéder à certaines étapes de nettoyage par voie chimique non corrosive vis à vis du cuivre. Ces étapes de nettoyage peuvent intervenir postérieurement au dépôt électrolytique de cuivre, ainsi qu'après l'étape de dépôt de la couche amorce de cuivre, ou bien encore le dépôt de la couche barrière à diffusion du cuivre.

On peut également procéder au dépôt d'une couche de passivation, typiquement obtenue par un premier dépôt d'une couche de nickel sur les spires de cuivre, recouvert d'un second dépôt d'une couche d'or. Cette couche de passivation peut également être obtenue par dépôt non sélectif d'une couche de chrome, puis gravure de cette couche en dehors des spires et motifs conducteurs.

L'invention concerne également un composant électronique pouvant être réalisé selon le procédé exposé ci-avant. Un tel composant incorpore un micro-composant inductif situé sur un substrat, et relié à ce dernier par au moins un plot métallique.

Ce composant comporte :
- au moins une superposition d'une couche de matériau à faible permittivité relative, et d'une couche de masque dur, la première couche de matériau à faible permittivité relative reposant sur la face supérieure du substrat ;
- un ensemble de spires métalliques, définies au-dessus de la superposition de couches de matériau à faible permittivité relative ;
- une couche barrière à la diffusion du cuivre, présente sur les faces inférieure et latérales des spires métalliques.

### Description sommaire des figures

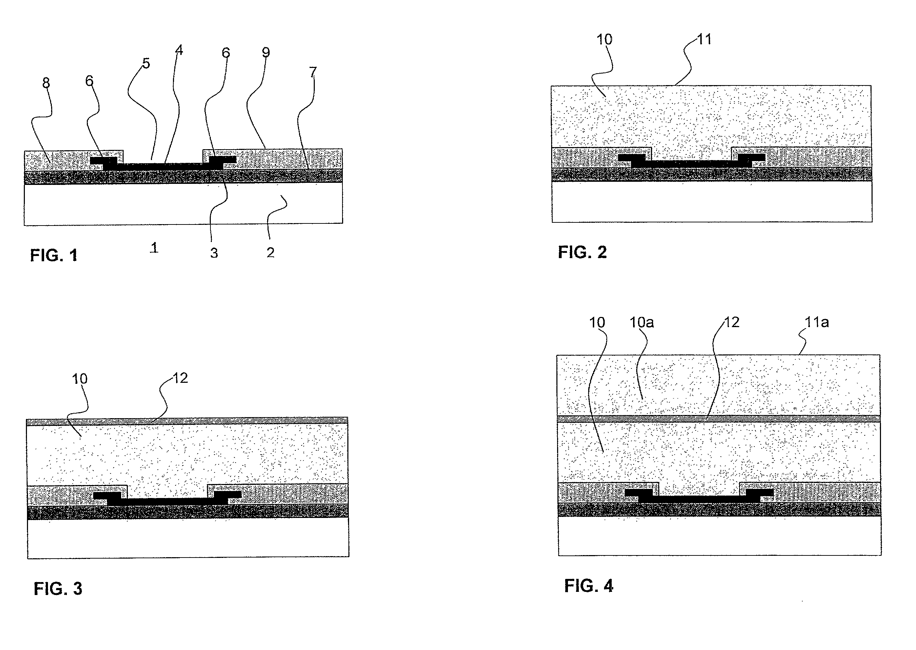

La manière de réaliser l'invention ainsi que les avantages qui en découlent ressortiront bien de la description de l'exemple de réalisation qui suit, à l'appui des figures 1 à 24 annexées, qui sont des représentations en coupe, au niveau d'un plot de connexion, du substrat et des différentes couches qui sont déposées au fur et à mesure des étapes du procédé. Les épaisseurs des différentes couches illustrées aux figures sont données pour permettre la compréhension de l'invention, et ne sont pas toujours en rapport avec les épaisseurs et dimensions réelles.

### Manière de réaliser l'invention

Comme déjà évoqué, l'invention concerne un procédé permettant de réaliser des micro-composants inductifs sur un substrat. Dans l'exemple illustré aux figures, le substrat (1) utilisé est un substrat ayant préalablement été traité de manière à former un circuit intégré. Néanmoins, d'autres substrats différents peuvent être utilisés, tel que notamment des substrats à base de quartz ou de verre.

Ainsi, un tel substrat (1), comme illustré à la figure 1 comporte le niveau supérieur (2) du circuit intégré proprement dit, surmonté d'une couche (3) de substrat dopé.

Dans la figure représentée, le substrat (1) comporte également un plot métallique (4), réalisé en aluminium, en alliage à base d'aluminium, ou en cuivre dont la face supérieure (5) est accessible. Les bords (6) de ce plot métallique, ainsi que la face supérieure (7) de la couche dopée sont recouverts d'une couche de passivation (8).

Le procédé conforme à l'invention peut enchaîner les différentes étapes décrites ci-après, étant entendu que certaines peuvent être réalisées de façon différente, tout en obtenant des résultats analogues. Certaines étapes peuvent être également considérées comme utiles mais non indispensables, et donc à ce titre être omises sans sortir du cadre de l'invention.

### Etape n° 1

La première étape consiste à assurer un nettoyage de la face supérieure (5) du plot de connexion métallique (4) ainsi que de la couche de passivation (8) déposée sur le substrat. Ce nettoyage se réalise par voie chimique humide.

### Etape n° 2

Comme illustré à la figure 2, on procède par la suite au dépôt d'une couche (10) de benzocyclobutène (BCB), ou d'un éventuel matériau équivalent, possédant une permittivité relative inférieure à 3. Ce dépôt est effectué par un procédé dit de "dépôt par rotation", également appelé "Spin-on deposition". L'épaisseur déposée est voisine de 20 micromètres.

### Etape n° 3

On procède par la suite à un nettoyage de la face supérieure (11) de la couche (10) de BCB. Ce nettoyage, effectué avec un bain approprié, assure le nettoyage et la préparation de la face supérieure (11) de la couche de BCB (10).

### Etape n° 4

Comme illustré à la figure 3, on procède par la suite au dépôt d'une couche (12) formant un masque dur au-dessus de la couche de BCB (10). Cette couche (12) présente une épaisseur supérieure à 200 Å. Le matériau employé est préférentiellement du carbure de silicium (SiC), mais il pourrait être également du SiOC, SiN, Si₃N_{4,} SiON, SiO_{4,} SiO₂, WSi₂ ou de l'Y₂O₃ ou tout autre matériau, dès lors que la sélectivité de gravure par rapport au matériau de la couche inférieure est au moins de 10 : 1. Cette couche (12) de masque dur peut être déposée par un procédé de dépôt chimique en phase vapeur assisté par plasma, ou PECVD pour "Plasma Enhanced Chemical Vapor Deposition".

### Etape n° 5

Par la suite, on procède à un dépôt d'une nouvelle couche (10a) de BCB, de la même manière qu'il est procédé à l'étape n° 2.

### Etape n° 6

On procède par la suite à un nettoyage de la face supérieure (11a) de la couche (10a) de BCB, comme pour l'étape n° 3 décrite ci-avant.

### Etape n° 7

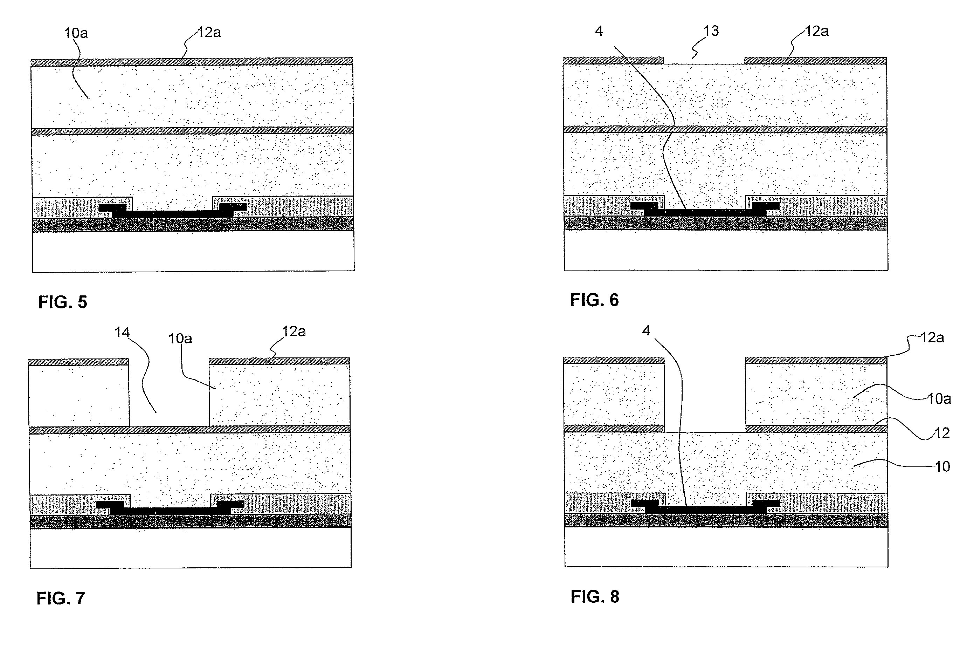

Comme illustré à la figure 5, on procède au dépôt d'une nouvelle couche (12a) formant le masque dur au-dessus de la couche de BCB (10a). Le mode opératoire est le même que celui décrit précédemment pour l'étape n°4.

Par la suite, il est possible de déposer de nouvelles couches de BCB surmontées d'un masque dur, autant de fois que nécessaire. Cet enchaînement d'étapes permet d'augmenter la distance entre le substrat et le futur composant inductif. Dans la forme illustrée aux figures, le composant ne comporte que deux couches de BCB, mais il va sans dire que l'invention couvre des variantes dans lesquelles le nombre de couches de BCB est supérieur, pouvant atteindre par exemple 5. Il est également possible de ne déposer qu'une seule couche de BCB, et une seule couche de masque dur, et ainsi de supprimer les étapes 5 à 7.

### Etape n° 8

Par la suite, on réalise une ouverture (13) dans le masque dur (12a), comme illustré à la figure 6 par un procédé de lithographie et une gravure chimique appropriée utilisant un procédé par voie humide tel qu'un bain à base d'acide hypophosphorique à la température de 180°C, si le masque dur est composé de nitrure de silicium, ou une gravure sèche par plasma utilisant un gaz réactif de fluorine tel que le CF₄ : H₂ par exemple.

### Etape n° 9

Par la suite, on procède comme illustré à la figure 7 à la gravure isotrope de la couche de BCB (10a), à l'aplomb du plot métallique de connexion (4), de manière à former la partie supérieure du trou d'interconnexion (14), également appelé via. La gravure de la couche (10a) de BCB peut s'effectuer notamment par l'emploi d'un mélange de gaz tel que le mélange Ar/CF₄/O₂ ou bien encore par un plasma radiofréquence utilisant d'autres réactants.

### Etape n° 10

On procède par la suite, comme illustré à la figure 8, à la gravure de la couche de masque dur (12), de manière qui est décrite à l'étape 8.

### Etape n° 11

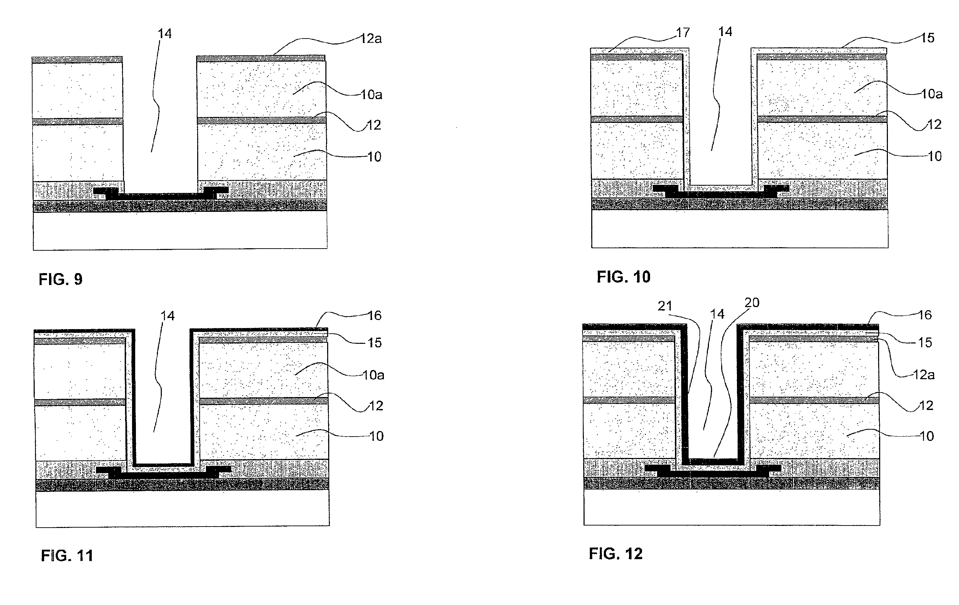

On procède par la suite, comme illustré à la figure 9, à la gravure de la couche de BCB (10), de la même manière que décrit à l'étape 9.

### Etape n° 12

On peut procéder par la suite à un nettoyage du trou d'interconnexion (14) selon différents procédés. Ainsi, il peut s'agir d'un nettoyage par voie chimique, mettant en oeuvre un mélange semi-aqueux non corrosif. On peut également assurer un nettoyage par voie sèche, en utilisant un plasma d'argon, sous une puissance de l'ordre de 300 kilowatts, en soumettant la zone (14) à des ondes radiofréquences pendant une durée voisine de la minute, et à température ambiante.

### Etape n° 13

Comme illustré à la figure 10, on procède par la suite au dépôt d'une couche (15) barrière à la diffusion du cuivre. Cette couche (15) recouvre le fond et les parois de la via (14), ainsi que les faces supérieures apparentes (17). Cette couche (15) est préférentiellement en en un alliage de titane et tungstène, ou bien en une superposition de titane et de nitrure de titane, ou bien encore de tantale et de nitrure de tantale. Cette couche (15) peut également être réalisée en nitrure de tungstène, ou bien par une simple couche de tungstène, de molybdène, d'osmium, ou de ruthénium. Cette couche (15), d'une épaisseur comprise entre 200 et 400 Å, peut être déposée par différentes techniques, et notamment par pulvérisation, procédé également connu sous l'abréviation de PVD - IMP pour "Physical Vapor Deposition - Ionized Metal Plasma", ou par des techniques de dépôt chimique en phase vapeur connue sous le nom de CVD "Chemical Vapor Deposition" et ALD "Atomic Layer Deposition".

D'autres procédés tels que notamment ceux connus sous l'abréviation de IMP pour "Ionised Metal Plasma" peuvent également être utilisés.

### Etape n° 14

Comme illustré à la figure 11, on procède par la suite au dépôt d'une couche (16) amorce de cuivre. Cette couche amorce (16) peut être déposée par différentes techniques, et notamment par pulvérisation, procédé également connu sous l'abréviation de PVD - IMP pour "Physical Vapor Deposition - Ionized Metal Plasma", ou par des techniques de dépôt chimique en phase vapeur connue sous le nom de CVD "Chemical Vapor Deposition" et ALD "Atomic Layer Deposition". La couche ainsi obtenue présente une épaisseur comprise typiquement entre 500 et 2000 Å.

### Etape n° 15

Par la suite, et comme illustré à la figure 12, on procède à une étape d'enrichissement de la couche amorce (16) par voie électrolytique. On peut utiliser un bain composé de sels de cuivre, tels que CuSO₄:5H₂O, rendus solubles dans un solvant tel que de l'acide sulfurique. Ce bain comprend également une base telle que l'hydroxyde de sodium et un chélate mono-denté tel que l'acide glycolique, un agent tampon tel que le CAPS (ou en développé: acide 3-(cyclohexylamino)-1-propane sulfonique) et un éther de glycol, en utilisant un courant soit continu, soit alternatif. On peut également procéder à un dépôt autocatalytique comprenant un agent réducteur tel que du diméthylamineborane, en substitution du courant électrolytique.

Cette étape d'enrichissement permet de combler les espaces entre les îlots de cuivre qui ont été préalablement déposés pour former la couche amorce. La surface de la couche amorce (16) est donc ainsi lissée, ce qui favorise l'étape ultérieure de dépôt électrolytique. Cette étape permet d'augmenter l'épaisseur de la couche amorce à l'intérieur de la via, et plus particulièrement sur les faces intérieures (21) et au fond (20) du trou d'interconnexion (14).

### Etape n° 16

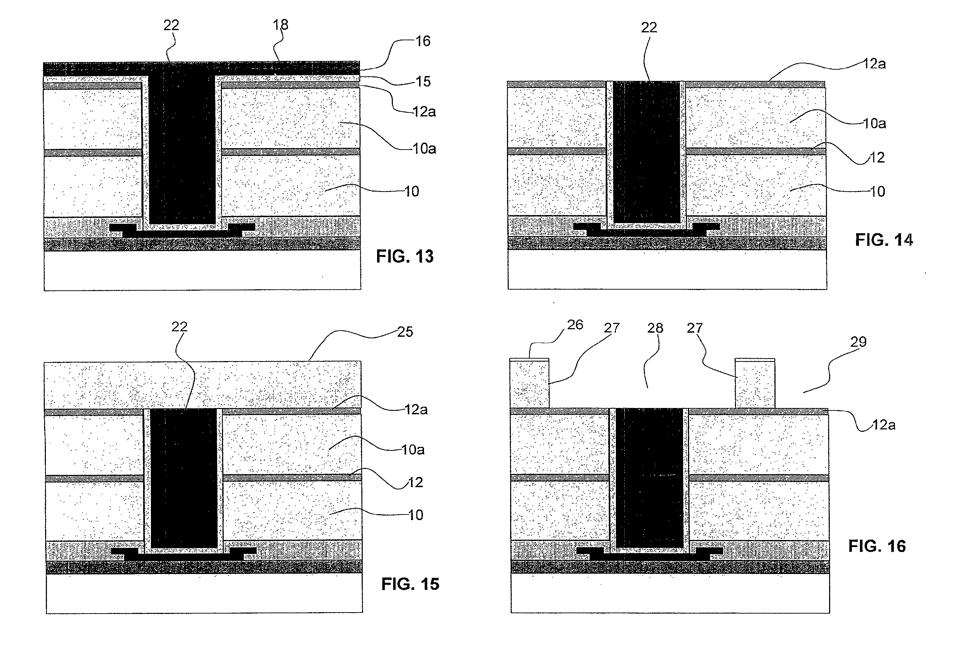

Par la suite, comme illustré à la figure 13, on procède à un dépôt électrolytique de cuivre, selon une technique dite de "croissance par le bas" correspondant à une technique particulière lorsque la micro structure est une damascène, et également connue sous l'appellation "bottom-up damascene superfilling". Cette étape permet de remplir le volume (22) de la via (14), et de recouvrir les faces supérieures (18) du composant au-dessus de la couche amorce (16). Cette étape utilise un bain d'électrolytes dont la formulation est définie pour obtenir une qualité de cuivre optimale, à savoir une résistivité avant croissance des grains lors d'un recuit compris entre 1,9 µΩ.cm et 2,3 µΩ.cm, et préférentiellement compris entre 2 µΩ.cm et 2,15 µΩ.cm.

Les bains utilisés peuvent par exemple être ceux commercialisés sous la dénomination "CU VIAFORM" par la Société ENTHONE, ou "CU GLEAM ELECTRO DEPOSIT 6000" par la Société SHIPLEY en utilisant un courant d'électrolyse d'onde variable et renverse comprenant donc un courant cathodique et un courant anodique dont les fréquences sont judicieusement définies en fonction de chacune des surfaces.

### Etape n° 17

Par la suite, on peut procéder à une étape de décontamination, permettant d'éliminer toute trace de cuivre qui serait susceptible de venir migrer dans le substrat ou dans tout autre partie sur laquelle les ions de cuivre ont pu se déposer. Cette étape de décontamination permet notamment de nettoyer l'arrière du substrat, ainsi que les zones périphériques du substrat. Parmi ces zones périphériques, on entend les faces latérales du substrat, perpendiculaires au plan principal du substrat ainsi que les arêtes du substrat sur lesquelles ont pu venir s'accumuler des dépôts superflus de cuivre.

Cette étape de décontamination s'effectue par voie chimique et humide au moyen d'outils permettant le traitement face par face du substrat, en utilisant un bain contenant par exemple un mélange de peroxyde d'hydrogène et d'acide sulfurique.

### Etape n° 18

On procède par la suite à une étape dite de recuit, permettant de réorganiser la structure cristalline du cuivre (22) déposé dans le trou d'interconnexion en faisant croître la taille des grains élémentaires cristallins. Cette étape utilise une technique connue sous le nom de RTP pour "Rapid Thermal Processing", pendant laquelle le composant est soumis à une température de l'ordre de 150 à 400°C, voisine préférentiellement de 300°C, pendant une durée de 10 secondes à 30 minutes, et préférentiellement de l'ordre de 5 minutes. Le composant est maintenu sous une atmosphère d'un gaz inerte, ou bien sous vide, évitant toute oxydation et diffusion de l'oxygène dans le milieu cristallin du cuivre.

La définition des paramètres est judicieusement définie pour obtenir une qualité de cuivre optimale et la structure cristalline recherchée, à savoir une résistivité après croissance des grains compris entre 1,72 µΩ.cm et 1,82 µΩ.cm.

### Etape n° 19

Par la suite, on procède comme illustré à la figure 14, à une opération de planarisation. Cette planarisation s'obtient par une technique de polissage mécano-chimique, connue sous l'abréviation de CMP. Plus précisément, il s'agit d'une opération de CMP utilisant une machine à bande, telle que notamment celle connue sous l'appellation "TERES" de la Société LAM RESEARCH

Cette planarisation permet d'éliminer la couche de cuivre (18) qui était déposée par voie électrolytique, ainsi que la couche amorce sous-jacente (16) et la couche barrière (15) située au-dessus du masque dur (12a). L'utilisation d'une machine CMP "à bande" permet de limiter les contraintes exercées sur la face supérieure du composant. Cette étape de planarisation enchaîne deux étapes distinctes et se base sur une réaction chimique en surface. La première étape du CMP utilise une abrasion sur un tissu de bande dur tel qu'un tissu de mousse polymérisée IC1000 proposé par l'entreprise Rodel. La solution chimique est un mélange aqueux permettant de graver de manière sélective le cuivre par rapport à 1a couche barrière par une formulation variable. Ce mélange comprend un agent oxydant tel que du peroxyde d'hydrogène, un solvant spécifique tel que des dérivés de triazole et tétrazole, des chélates et catalyseurs de réaction tels que des sels de Rochelle ou des citrates d'ammonium, un agent inhibiteur de corrosion tel que du BTA, de l'eau et des particules abrasives composées soit d'alumine soit d'oxyde de cérium, soit de cyanites de fer. Cette première étape chimique a pour fonction de graver le cuivre déposé en excès au-dessus de la microstructure Damascène par un taux d'abrasion important évalué entre 150 et 200 nanomètres par minute.

La seconde étape de CMP utilise un tissu de bande plus souple tel que le IC400 de l'entreprise Rodel. La solution chimique aqueuse permet de graver la couche barrière et le cuivre en le lissant par une action chimique en utilisant entre autres, des particules suspendues du type Klébosol de silice ou d'oxyde de Cérium servant d'abrasif, et une phase aqueuse composée de composés d'amines organiques comme le diéthylènetétraamine , un agent inhibiteur de corrosion tel que du BTA (benzotriazole) et comme solvant de l'eau et de l'IPA (isopropylalcool). Mais d'autres solutions correspondant aux critères de la présente invention existent d'ores et déjà sous forme commerciale. On peut notamment citer les solutions chimiques et abrasives dans les séries Microplanar™ CMP9000™ proposées par l'entreprise EKC Technology (basée à 2520 Barrington Court Hayward, CA 94545-1163).

### Etape n° 20

Par la suite, on procède à une étape de nettoyage de la face supérieure du composant poli. Ce nettoyage permet de retirer les résidus de polissage composés de colloïdes à base de complexes d'oxyde de cuivre, sans avoir à graver la couche supérieure de cuivre qui vient d'être polie, et sans provoquer de phénomènes de corrosion par un bain à un pH déterminé. Des bains chimiques sont proposés par des fabricants tels que la société EKC Technology comme le produit commercial connu sous le nom de "MicroPlanar™ PCMP5000™ series" ou des solutions chimiques aqueuses composées d'un chélate mono ou polydenté tel que des ions alcalins de gluconate, de citrate ou oxalate, un acide fluoré tel que de l'acide fluorhydrique et un agent inhibiteur de corrosion tel qu'un dérivé d'imidazole.

### Etape n° 21

Par la suite, comme illustré à la figure 15, on procède au dépôt d'une couche de résine supérieure (25). Cette couche (25) est réalisée en un matériau de faible permittivité relative, telle que notamment du BCB ou préférentiellement du polyimide. Ce matériau est déposé selon une technique de dépôt par rotation également appelée "Spin-on deposition". L'épaisseur de résine supérieure (25) ainsi déposée est de l'ordre de grandeur de la hauteur des spires du micro-composant inductif. On peut par exemple utiliser du polyimide choisi dans la famille des polyimides photo sensibles tel que les PI-2771, PI-2727, ou PI-2730 commercialisés par la société DuPont de Nemours. D'autres polyimides tels que ceux commercialisés sous les références PI-2600 Series, PI-2545 Series par DuPont de Nemours peuvent être employés, dans le cas où l'on réalise une étape de photo-lithographie et un procédé de gravure humide ou sèche basé sur l'emploi d'un plasma, pour définir la topographie dans le polyimide

### Etape n° 22

On procède par la suite au dépôt d'une résine de lithographie (26) au-dessus de la couche de résine supérieure. Cette résine est ensuite insolée pour définir les formes des futures spires et autres motifs conducteurs.

### Etape n° 23

On procède par la suite à une gravure de la couche de résine supérieure (25) pour obtenir, comme illustré à la figure 16, des différents canaux (28, 29) séparés les zones (27) de résine supérieure qui n'ont pas été gravées.

### Etape n° 24

On procède par la suite à une étape de nettoyage par l'application d'un bain non corrosif du cuivre, afin de retirer tous les résidus engendrés par l'étape de lithographie. Cette étape permet de nettoyer la face supérieure du cuivre (22) emplissant la via, ainsi que l'élimination des portions (26) de résine de lithographie se trouvant au-dessus des zones (27) de résine supérieure (25). Le nettoyage s'obtient par voie chimique, en utilisant des bains incluant des composants aminés et des molécules anti-corrosives du cuivre tel que du benzotriazole, ou des composants tels que l'ACT 970 commercialisé par la Société ASHLAND.

### Etape n° 25

On procède par la suite au dépôt d'une couche (35) barrière à la diffusion du cuivre, de la même manière que décrit pour l'étape n° 13 ci-avant.

### Etape n° 26

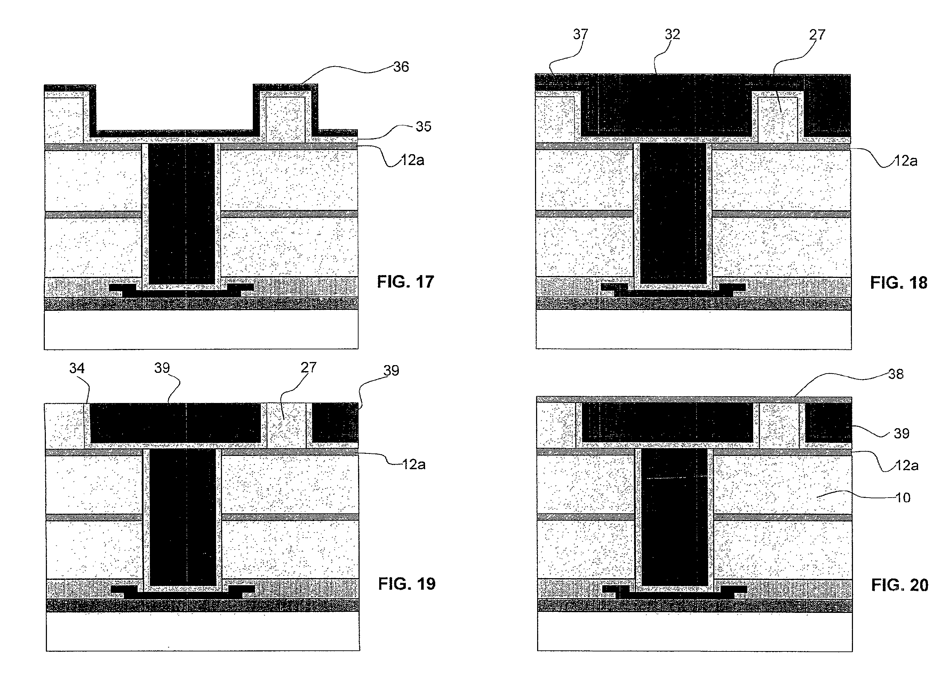

On procède par la suite comme illustré à la figure 17 au dépôt d'une couche amorce de cuivre (36) de la même manière que celle décrite pour l'étape n° 14 ci-avant. Cette couche amorce (36) est ensuite enrichie de la même manière que décrite à l'étape n° 15 ci-avant.

### Etape n° 27

Par la suite, on procède comme illustré à la figure 18 au dépôt d'une couche de cuivre (32) dans la microstructure Damascène, comme décrit à l'étape n° 16 ci-avant.

### Etape n° 28

On procède par la suite à une étape de décontamination similaire à celle décrite dans l'étape n° 17 ci-avant.

### Etape n° 29

On procède par la suite à une étape de recuit telle que décrite à l'étape n° 18 ci-avant.

### Etape n° 30

Par la suite, comme illustré à la figure 19, on procède à une planarisation, par une CMP à bande, de la même façon que dans l'étape n° 19 décrite ci-avant. Cette planarisation s'effectue jusqu'à l'élimination de la couche (37) de cuivre située au-dessus des zones restantes (27) de la résine supérieure. Cette étape élimine également la couche amorce (36) ainsi que la couche (35) barrière à diffusion du cuivre qui se trouve au-dessus de ces zones restantes (27).

La présence de la couche (35) barrière à la diffusion du cuivre sur les zones verticales (34) séparant les spires et la résine supérieure évite tout problème de migration du cuivre dans le polyimide, phénomène qui aurait tendance à apparaître lors des étapes de recuit pendant lesquelles le composant est soumis à une température élevée.

### Etape n° 31

Par la suite, on procède comme pour l'étape n° 20, à un nettoyage de la face supérieure du composant.

### Etape n° 32

Par la suite, on procède, comme illustré à la figure 20, au dépôt par pulvérisation d'une couche de chrome (38). Cette couche de chrome (38), d'une épaisseur comprise entre 100 et 500 Å, et préférentiellement au voisinage de 250 Å, joue un rôle de barrière de protection pour les spires de cuivre (39) qu'elle recouvre.

Cette couche de chrome (38) possède une bonne adhésion sur le polyimide formant les zones restantes (27) de la résine supérieure (25). Cette couche de chrome (38) joue également un rôle de barrière à l'oxydation.

### Etape n° 33

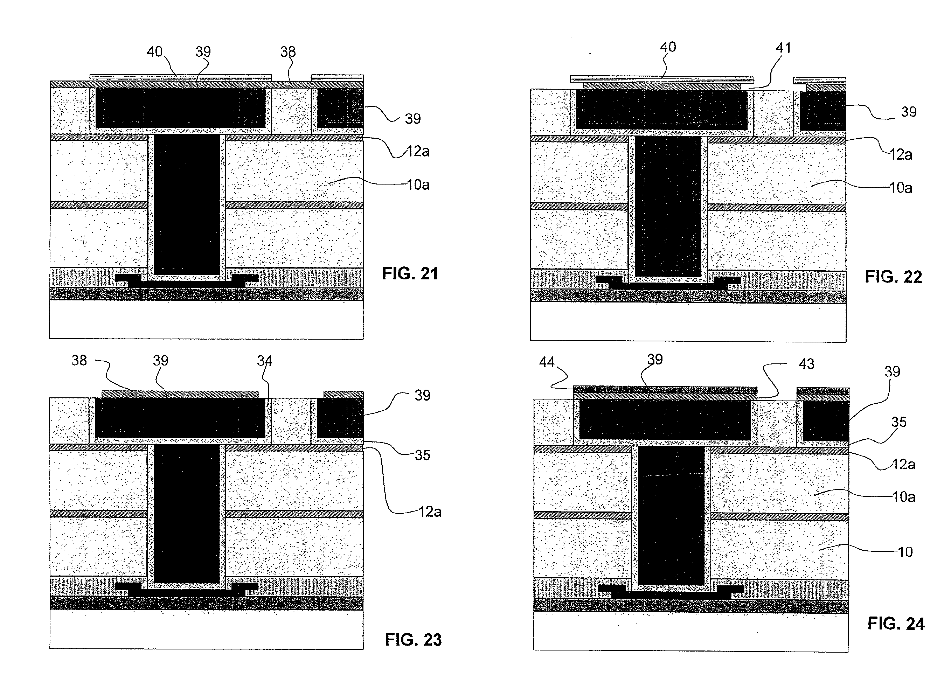

Par la suite, comme illustré à la figure 21, on procède au dépôt d'un masque de lithogravure (40) au-dessus de la couche de chrome (38), à l'aplomb des spires (39) et des éventuels motifs conducteurs.

### Etape n° 34

Par la suite, comme illustré à la figure 22, on procède à une étape de gravure humide de la couche de chrome (38). Cette gravure étant anisotrope, on observe des phénomènes de surgravure (41) en bordure des motifs de résine de lithographie (40).

### Etape n° 35

Par la suite, comme illustré à la figure 23, on procède au décapage de la résine (40) recouvrant la couche de chrome (38).

### Etape n° 36

Par la suite, on procède à une étape de nettoyage non corrosif pour le cuivre identique à celle décrite aux étapes n° 12 et 24.

On notera que le dépôt de la couche de passivation de chrome (38) faisant l'objet des étapes n° 34 et 35 peut être remplacé, comme illustré à la figure 24, par la succession d'un dépôt sélectif d'une couche de nickel (43) et d'une couche d'or (44), uniquement au-dessus des spires (39) et des motifs conducteurs.

Il ressort de ce qui précède que le procédé conforme à l'invention permet d'obtenir des micro-composants inductifs qui présentent un très fort facteur de qualité, du fait d'un éloignement important entre le substrat et le plan principal du micro-composant inductif. Typiquement, les facteurs de qualité obtenus sont supérieurs à 50 à la fréquence de l'ordre de 2 GigaHertz avec des topologies de spires constituant le micro-composant inductif dont le motif est définie par une largeur de spire inférieure à 3 micromètres et une hauteur supérieure à 10 microns, et une distance entre les spires pouvant être inférieure à 3 micromètres

La décomposition du dépôt électrolytique de cuivre en deux étapes distinctes permet d'assurer une optimisation de la régularité de la forme des différentes spires, sans augmentation du coût de fabrication, et ainsi donc une bonne reproductibilité du procédé conduisant à la réalisation du micro-composant possédant des caractéristiques électriques proches de celles définies lors de la conception.

Il est également possible grâce à ce procédé de réaliser différents motifs conducteurs servant de pistes conductrices de reroutage, permettant d'interconnecter par un décalage spatial des plots d'interconnexion (pads) et des niveaux de métallisation des transistors. Ceci est obtenu tout en limitant la résistance et l'effet capacitif ainsi qu'en augmentant la résistance à l'électromigration des atomes de cuivre dans les lignes et voies d'interconnexion.

En outre, le procédé conforme à l'invention permet de maîtriser les interfaces entre les différentes couches de matériau déposé, avec pour conséquence une nette amélioration des performances du dispositif et une réduction des sources de défectivité.

## Revendications

1. Procédé de fabrication d'un composant électronique, incorporant un micro-composant inductif, situé au-dessus d'un substrat (1), et relié à ce dernier par au moins un plot métallique (4), **caractérisé en ce qu'**il comporte les étapes suivantes, consistant successivement à :
a) déposer sur le substrat au moins un empilement d'une couche (10, 10a) de matériau à faible permittivité relative et d'une couche (12, 12a) formant un masque dur ;
b) réaliser une ouverture (13) dans la couche de masque dur (12a) située en position supérieure, à l'aplomb des plots métalliques (4) ;
c) graver la ou les couches (10, 10a) de matériau à faible permittivité relative et la ou les couches de masque dur sous-jacent jusqu'au plot métallique (a), pour former un trou d'interconnexion (14);
d) déposer une couche (15) formant barrière à la diffusion du cuivre ;
e) déposer une couche amorce (16) de cuivre ;
f) déposer par voie électrolytique une couche de cuivre (32) emplissant le trou d'interconnexion et recouvrant la couche amorce (16) ;
g) planariser la face supérieure jusqu'à faire apparaître la couche de masque dur supérieure (12a);
h) déposer une couche de résine supérieure (25) formée d'un matériau à faible permittivité relative ;
i) graver la couche de résine supérieure (25) pour former les canaux (28, 29) définissant les spires du micro-composant inductif, et d'éventuels autres motifs conducteurs ;
j) déposer une couche barrière (35) à la diffusion du cuivre ;
k) déposer une couche (36) amorce de cuivre ;
l) déposer par voie électrolytique du cuivre (32) au moins au-dessus des canaux (28, 29) ainsi gravés ;
m) planariser jusqu'à faire apparaître la couche de résine supérieure (25).

2. Procédé selon la revendication 1, **caractérisé en ce qu'**il comporte également une étape le dépôt d'une couche de passivation au-dessus des spires de cuivre.

3. Procédé selon la revendication 2, **caractérisé en ce que** la couche de passivation est obtenue par dépôt non sélectif d'une couche de chrome (38), puis gravure de cette couche en dehors des spires (39) et des motifs conducteurs.

4. Procédé selon la revendication 2, **caractérisé en ce que** la couche de passivation est obtenue par dépôt sélectif d'une couche de nickel (43) au-dessus des spires et motifs conducteurs, puis par dépôt sélectif d'une couche d'or (44).

5. Procédé selon la revendication 1, **caractérisé en ce que** le substrat (1) est un substrat semi-conducteur, formant un circuit intégré.

6. Procédé selon la revendication 1, **caractérisé en ce que** le substrat est un substrat amorphe du type verre ou quartz.

7. Procédé selon la revendication 1, **caractérisé en ce que** le matériau (10, 10a) de faible permittivité relative, déposé sur le substrat est du benzocyclobutène.

8. Procédé selon la revendication 1, **caractérisé en ce que** l'épaisseur de la couche (10, 10a) de matériau de faible permittivité relative est comprise entre 10 et 40 micromètres, préférentiellement de 20 micromètres.

9. Procédé selon la revendication 1, **caractérisé en ce que** le matériau utilisé pour la couche (12, 12a) formant le masque dur est choisi dans le groupe comprenant : SiC, SiN, Si₃N_{4,} SiO₂, SiOC, SiON, WSi₂, Y₂O₃ pris isolément ou en combinaison.

10. Procédé selon la revendication 1, **caractérisé en ce que** le matériau utilisé pour la couche (15,35) barrière à la diffusion du cuivre est choisi dans le groupe comprenant TiW, Ti, TiN, Ta, TaN, W, WN, Re, Cr, Os, Mo, Ru, pris isolément ou en combinaison.

11. Procédé selon la revendication 1, **caractérisé en ce que** l'épaisseur de la couche (15, 35) barrière à la diffusion du cuivre est comprise entre 100 et 400 Å.

12. Procédé selon la revendication 1, **caractérisé en ce qu'**il comporte une étape d'enrichissement de la couche (16, 36) amorce de cuivre.

13. Procédé selon la revendication 1, **caractérisé en ce qu'**il comporte une étape de recuit, destinée à faire croître la taille des cristaux de cuivre déposés lors des étapes de dépôt électrolytique.

14. Procédé selon la revendication 1, **caractérisé en ce qu'**il comporte une étape de décontamination du cuivre susceptible de migrer dans le substrat (1), notamment au niveau des faces latérales du substrat.

15. Procédé selon la revendication 14, **caractérisé en ce que** l'étape de décontamination a lieu à la suite au moins une des étapes de dépôt électrolytique.

16. Procédé selon la revendication 1, **caractérisé en ce qu'**il comporte au moins une étape de nettoyage par voie chimique non corrosive vis à vis du cuivre postérieurement aux dépôts électrolytiques de cuivre, et/ou aux étapes de gravure de la couche amorce (16, 36) de cuivre, et/ou de la couche barrière (15, 35) à la diffusion du cuivre.

17. Procédé selon la revendication 1, **caractérisé en ce que** le dépôt de cuivre destiné à former les spires (39) est effectué pour donner une épaisseur de cuivre supérieure à 10 micromètres.

18. Composant électronique, incorporant un micro-composant inductif situé au-dessus d'un substrat (1), relié à ce dernier par au moins un plot métallique (4), **caractérisé en ce qu'**il comporte :
- au moins une superposition d'une couche (10, 10a) de matériau à faible permittivité relative et d'une couche de masque dur, la première couche (10) de matériau à faible permittivité relative reposant sur la face supérieure du substrat (1);
- un ensemble de spires métalliques (39), définies au-dessus de la superposition de couches (10, 10a) de matériau à faible permittivité relative ;
- une couche (35) barrière à la diffusion du cuivre, présente sur les faces inférieure et latérales des spires métalliques (39).

19. Composant selon la revendication 18, **caractérisé en ce que** le substrat est un substrat semi-conducteur, formant un circuit intégré.

20. Composant selon la revendication 18, **caractérisé en ce que** le substrat est un substrat amorphe du type verre ou quartz.

21. Composant selon la revendication 18, **caractérisé en ce que** le matériau (10, 10a) de faible permittivité relative déposé sur le substrat est du benzocyclobutène.

22. Composant selon la revendication 21, **caractérisé en ce que** l'épaisseur de la couche (10, 10a) de matériau de faible permittivité relative est comprise entre 10 et 40 micromètres, de préférence voisine de 20 micromètres.

23. Composant selon la revendication 18, **caractérisé en ce que** le matériau utilisé pour la couche (15, 35) barrière à la diffusion du cuivre est choisi dans le groupe comprenant TiW, Ti, TiN, Ta, TaN, Mo, W, WN, Re, Cr, Os, et Ru, pris isolément ou en combinaison.

24. Composant selon la revendication 18, **caractérisé en ce que** l'épaisseur de la couche (15,35) barrière à la diffusion du cuivre est comprise entre 100 et 400 Å.

25. Composant selon la revendication 18, **caractérisé en ce qu'**il comporte une couche de passivation présente sur les spires de cuivre, ladite couche incluant typiquement du nickel (43) et de l'or (44), ou du chrome (38).

26. Composant selon la revendication 18, **caractérisé en ce que** l'épaisseur des spires (39) est supérieure à 10 micromètres.

27. Composant selon la revendication 18, **caractérisé en ce que** la largeur des spires (39) est inférieure à 3 micromètres.

28. Composant selon la revendication 18, **caractérisé en ce que** la distance entre les spires (39) est inférieure à 3 micromètres.

29. Composant selon la revendication 18, **caractérisé en ce que** le facteur de qualité du micro-composant inductif est supérieur à 50, à 2 GigaHertz.

30. Composant selon la revendication 18, **caractérisé en ce que** la résistivité des spires est comprise entre 1,72 µΩ.cm et 1,82 µΩ.cm.
